# EUROPEAN PATENT SPECIFICATION

(11) **EP 2 261 033 B1**
(45) Date of publication and mention of the grant of the patent: **27.08.2014**
(21) Application number: 10165355.8
(22) Date of filing: 09.06.2010
(51) Int. Cl.: B41C 1/10, B41N 3/08, G03F 7/033, G03F 7/09, G03F 7/32

(54) **Method of preparing lithographic printing plate**
Verfahren zur Herstellung einer Lithographiedruckplatte
Procédé de préparation de plaque d'impression lithographique

(30) Priority: 09.06.2009 JP 2009138617
(43) Date of publication of application: 15.12.2010
(73) Proprietor: Fujifilm Corporation, Minato-ku Tokyo (JP)
(72) Inventor: Iwai, Yu, Shizuoka (JP)
(74) Representative: HOFFMANN EITLE

(56) References cited:
- EP-A1- 1 204 000
- EP-A1- 2 105 797
- EP-A2- 1 220 041
- WO-A1-2009/119827
- US-A1- 2002 142 249

## Description

### Background of the invention

### 1. Field of the Invention

The present invention relates to a method of preparing a lithographic printing plate, particularly, to a method of preparing a Lithographic printing plate using a lithographic printing plate precursor suitable for simple processing.

### 2. Description of the Related Art

With respect to hitherto known lithographic printing plate precursors (hereinafter, also referred to as PS plates), since a step of removing the non-Image area by dissolution (development processing) with strong alkali after imagewise exposure is performed, a post-processing step, for example, washing of the printing plate after the development processing with water, treatment of the printing plate after the development processing with a rinse solution containing a surfactant or treatment of the printing plate after the development processing with an oil-desensitizing solution containing gum arabic or a starch derivative, is necessary. The point that such an additional wet treatment is indispensable is a large subject of investigation in hitherto known PS plates. Particularly, the consideration for global environment has become a great concern throughout the field of industry in recent years. In view of the consideration for global environment, a treatment with a developer closer to a neutral range and reduction in the amount of waste liquid are subjects of further investigation. Further, it is desirable that the wet type post-processing is simplified.

From this viewpoint, as one method for eliminating the post-processing step, a. method referred to as on-press development wherein an exposed lithographic printing plate precursor is mounted on a cylinder of a printing machine and the non-image area of the lithographic printing plate precursor is removed by supplying dampening water and ink while rotating the cylinder is known. Specifically, according to the method, the lithographic printing plate precursor is exposed and mounted on a printing machine as it is to complete development processing in a conventional process of printing (see, for example. Patent Document 1). Also, a method is known wherein a water washing step prior to a development step is omitted, development is performed using a developer having a pH range lower than a developer used in hitherto known alkali development and after the development step, a post-water washing step and an oil-desensitizing treatment step (gum solution treatment step) are not conducted (see, for example, Patent Documents 2 and 3). However, as for a lithographic printing plate precursor comprising an image-recording layer containing polyvinyl butyral and a protective layer containing polyvinyl alcohol, when the water washing step prior to a development step is omitted, the polyvinyl butyral in the image-recording layer and the polyvinyl alcohol in the protective layer precipitate in the developer so that it is necessary to exchange the developer at short intervals and to clean the polyvinyl butyral and polyvinyl alcohol adhered to a developing machine with warm water. In order to solve the problem, when the polyvinyl butyral is not used in the image-recording layer, durability of the image-recording layer deteriorates to cause decrease in panting durability, On the other hand, when the polyvinyl alcohol is not used in the protective layer, due to increase in the oxygen permeability, polymerization sensitivity reduces to cause a problem of decrease in printing durability.

Also, in order to increase stability of an aqueous solution of polyvinyl alcohol, a method of incorporating specific alcohols, ketones, pyridines, phenols or rhodan salts into the aqueous solution of polyvinyl alcohol is known (see Non-Patent Document 1). However, there is no description on incorporation of the specific compounds into a development processing solution for a printing plate precursor and the effects thereof in the developing processing solution and the influences on the printing plate have not been known.

EP 1 204 000 A1 describes a negative photosensitive lithographic printing plate comprising a photosensitive layer containing a polyvinyl alcohol resin binder modified with an acetal skeleton having an alicyclic structure. US 2002/142249 A1 describes a negative photosensitive lithographic printing plate comprising a support and a photosensitive layer containing, inter alia, a modified polyvinyl alcohol resin binder having a radical polymerizable group and an acid group. The image-receiving layer disclosed therein does not contain polyvinyl butyral. EP 1 220 041 A2 describes a method for preparing a lithographic printing plate, in which a photosensitive layer comprising a diazo resin and an organic polymer compound is used. The organic polymer compound disclosed therein is a modified polyvinyl acetal resin which may contain a unit of polyvinyl butyral and the developer solution used in the method may contain an alcohol having 6 carbon atoms.
[Patent Document 1] JP-A-2005-125749 (the term "JP-A" as used herein means an "unexamined published Japanese patent Application")
[Patent Document 2] EP-A-1751625
[Patent Document 3] EP-A-186S036
[Non-Patent Document 1] "Poval" written by Koichi Nagano, Saburo Yamane and Kentaro Toyoshima

### Summary of the Invention

Therefore, an object of the present invention is to provide a method of preparing a lithographic printing plate which makes it possible to conduct direct plate making based on digital data, for example, from a computer, by image-recording using a solid laser or semiconductor laser emitting an ultraviolet ray or visible light, which makes it possible to remove an unexposed area of an image-recording layer and a protective layer at the same time, which is excellent in a developing property and a printing image-forming property, which provides a lithographic printing plate having high printing durability, and which can improve a processing property of a development processing solution to reduce exchange frequency of the development processing solution.

As a result of the intensive investigation, the inventors have found that the above-described object can be achieved by using a method of preparing a lithographic printing plate described below.

Specifically, the present invention includes the following items.
(1) A method of preparing a lithographic printing plate, comprising:
   exposing imagewise a lithographic printing plate precursor comprising a support, an image-recording layer containing a polymerization initiator, a polymerizable compound and polyvinyl butyral and a protective layer containing polyvinyl alcohol in this order to cure an exposed area of the image-recording layer,
   removing an unexposed area of the image-recording layer and the protective layer using a development processing solution containing at least one compound selected from the group consisting of a phenol having prom 6 to 10 carbon atoms and a compound represented by formula (1) shown below in an amount of 0.1 to 20% by weight thereby forming an image:

      Xⁿ⁺(SCN)ₙ Formula (1)

      wherein Xⁿ⁺ represents a counter cation and n represents a valence of the counter cation X.
(2) The method of preparing a lithographic printing plate as described in (1) above, wherein pH of the development processing solution is from 2.0 to 11.0.
(3) The method of preparing a lithographic printing plate as described in (1) or (2) above, wherein pH of the development processing solution is from 5.0 to 10.7.
(4) The method of preparing a lithographic printing plate as described in any one of (1) to (3), wherein the development processing solution further contains a surfactant.
(5) The method of preparing a lithographic printing plate as described in (4), wherein the surfactant includes both a nonionic surfactant and an anionic surfactant.
(6) The method of preparing a lithographic printing plate as described in any one of (1) to (5), wherein the development processing solution further contains a water-soluble polymer compound.
(7) The method of preparing a lithographic printing plate as described in any one of (1) to (6) above, wherein the polyvinyl butyral contains an acid group.

The functional mechanism of the invention is presumed as follows.

Specifically, by incorporating at least one of a phenol having from 6 to 10 carbon atoms and an inorganic salt represented by formula (1) shown below in an amount of 0.1 to 20% by weight in a development processing solution, not only development removability of a protective layer containing polyvinyl alcohol is improved but also precipitation of polyvinyl alcohol in the development processing solution can be prevented. Ordinarily, when polyvinyl butyral is used in an image-recording layer, the precipitation of polyvinyl alcohol in the development processing solution is more accelerated. However, the precipitation of polyvinyl alcohol can be prevented by incorporating the compound described above into the development processing solution. It is presumed that the precipitation of polyvinyl alcohol generated by using polyvinyl butyral in the image-recording layer arises from that the polyvinyl butyral is hydrolyzed in the development processing solution to form polyvinyl alcohol. On the contrary, when the compound described above is incorporated in an amount of 0.1 to 20% by weight into the development processing solution, not only solubility of the unexposed area of the image-recording layer in the development processing solution increases, but also the effect of maintaining the high solubility in the development processing solution, is generated thereby effectively preventing the precipitation of polyvinyl alcohol in the development processing solution.

According to the present invention, therefore, a method of preparing a lithographic printing plate which makes it possible to conduct direct plate making based on digital data, for example, from a computer, by image-recording using a solid laser or semiconductor laser emitting an ultraviolet ray or visible light, which makes it possible to remove an unexposed area of an image-recording layer and a protective layer at the same time, which is excellent in a developing property and a printing image-forming property, which provides a lithographic printing plate having high printing durability, and which can improve a processing property of a development processing solution to reduce exchange frequency of the development processing solution can be provided.

### Brief description of the drawing

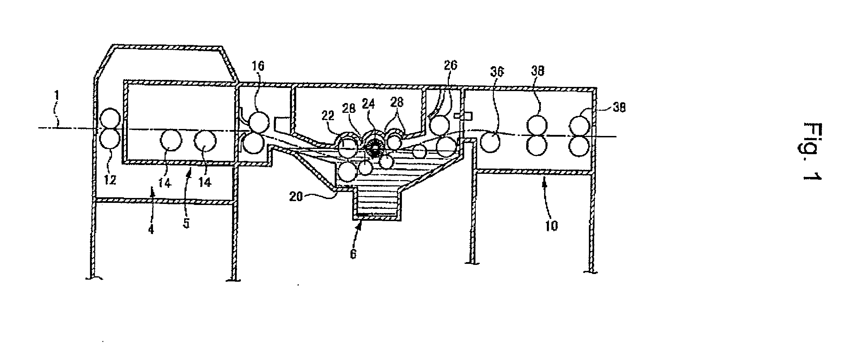

Fig. 1 is a view schematically showing a configuration of an automatic development processor.

### Description of reference numerals and signs

1: Lithographic printing plate precursor
4: Pre-heating unit
5: Heating chamber
6: Developing unit
10: Drying unit
12: Carrying-in roller
14: Skewer roller
16: Transport roller
20: Developing tank
22: Transport roller
24: Brush roller
26: Squeeze roller
28: Backup roller
36: Guide roller
38: Skewer roller

### DETAILED DESCRIPTION OF THE INVENTION

In the specification, with respect to the description of a group in a compound represented by a formula, when the group is not indicated whether substituted or unsubstituted, unless otherwise indicated specifically, the group includes not only the unsubstituted group but also the substituted group, if the group is able to have a substituent. For example, the description "R represents an alkyl group, an aryl group or a heterocyclic group" in a formula means that "R represents an unsubstituted alkyl group, a substituted alkyl group, an unsubstituted aryl group, a substituted aryl group, an unsubstituted heterocyclic group or a substituted heterocyclic group".

The method of preparing a lithographic printing plate according to the invention comprises exposing imagewise a lithographic printing plate precursor comprising a support having provided thereon an image-recording layer containing polyvinyl butyral and a protective layer containing polyvinyl alcohol in this order to cure the exposed area of the image-recording layer and then removing the unexposed area of the image-recording layer and the protective layer using a development processing solution containing at least one compound (hereinafter, also referred to as a "specific compound") selected from a phenol having from 6 to 10 carbon atoms and a compound represented by formula (1) shown below in an amount of 0.1 to 20% by weight thereby forming an image.

Xⁿ⁺(SCN)ₙ Formula (1)

In formula (1), Xⁿ⁺ represents a counter cation and n represents a valence of the counter cation X.

The method of preparing a lithographic printing plate according to the invention will be described in detail below.

### [Method of preparing lithographic printing plate]

According to the invention, a lithographic printing plate precursor is exposed imagewise and then subjected to development processing to prepare a lithographic printing plate. The development processing includes (1) a method of developing with an alkali developer (having pH higher than 11.0), (2) a method of developing with a developer having pH of 2.0 to 11.0, and (3) a method of developing (on-press development) by supplying dampening water and/or ink on a printing machine. According to the invention, the method of developing with a developer having pH of 2.0 to 11.0 is preferably used.

Specifically, the lithographic printing plate precursor according to the invention is subjected to the development processing with the developer having pH of 2.0 to 11.0 to remove together a protective layer and the unexposed area of the image-recording layer so that the resulting lithographic printing plate can be immediately mounted on a printing machine to perform printing. According to a conventional developing process using an alkali developer as the method (I), a protective layer is removed in a pre-water washing step, the alkali development is conducted, the alkali is removed by washing with water in a post-water washing step, gum solution treatment is conducted and drying is conducted in a drying step. According to the invention, the developer preferably further contains a surfactant or a water-soluble polymer compound and the development and gum solution treatment are preferably conducted at the same time. Therefore, the post-water washing step is not necessary, and after conducting the development and gum solution treatment with one solution, the drying step is preferably performed. Moreover, the pre-water washing step is also not necessary and the removal of protective layer is also preferably conducted simultaneously with the development and gum solution treatment. It is preferred that after the development and gum treatment, the excess developer is removed using a squeeze roller, followed by conducting drying. The development of the lithographic printing plate precursor according to the invention is performed at temperature ordinarily from 0 to 60°C, preferably from about 15 to about 40°C, using, for example, a method wherein the exposed lithographic printing plate precursor is immersed in the developer and rubbed with a brush or a method wherein the developer is splayed to the exposed lithographic printing plate precursor and the exposed lithographic printing plate precursor is rubbed with a brush. The development processing can be performed by an automatic development processor and thus, it is advantageous in view of being free from the measures against development scum resulting from the protective layer and/or image-recording layer encountered in case of the on-press development (3).

Now, the development processing solution for use in the method of preparing a lithographic printing plate according to the invention is described in detail below.

### <Specific compound>

The development processing solution (hereinafter, also simply referred to as a "developer") according to the invention contains the Specific compound from the standpoint of processing property and developing property. By incorporating the specific compound into the development processing solution according to the invention, even when the image-recording layer containing polyvinyl butyral and the protective layer containing polyvinyl alcohol are used, the high processing property and excellent developing property can be achieved. The specific compound for use in the development processing solution is at least one of a phenol having from 6 to 10 carbon atoms and a compound represented by formula (1) shown below.

Xⁿ⁺(SCN)ₙ Formula (1)

In formula (1), Xⁿ⁺ represents a counter cation and n represents a valence of the counter cation X,

The alcohol having from 3 to 10 carbon atoms which does not fall within the scope of the present invention specifically includes, for example, 1-propanol, 2-propanol, 1-butanol, 2-butanol, 2-metbyl-1-propanol, 2-methyl-2-propanol, 1-pentanol, 2-pentanol, 3-pentanol, 2-methyl-1-butanol, 3-methyl-1-butanol, 2-methyl-2-butanol, 3-methyl-2-hutanal, 2,2-ditnethyl-1-propanol, 1-hexanol, 2-hexanol, 3-hexanol, 1,5-pentanediol, 4-methyl-1-pentanol, 1-heptanol, 2-methyl-1-heptanol, 3-methyl-1-heptanol, 1,6-hexanediol, 2-heptanol. 3-heptanol, 3-methyl-1-hexanol, 4-methyl-l-hexanol, 2-cyclopentancethanol, 5-methyl-2-hyxanol, 1-oatanol, cyclohexaneethanol, cyc1ohexanemethanol, 1,7-heptanediol, 1,2-hexanediol, 2-methyl-2-hexanol, 4-heptanol, 2,5-hexanediol, 5-methyl-1-heptanol. 2-octanol, 3-octanol, 4-octanol, 3-methyl-1,5-pentanediol, 2-ethyl-1-hexanol, cycloheptanol, 1-nonanol, 3-methyleyelohexanol, 4-methylcyclohexanol, 2-methyl-3-licxmol, 6-methyl-3-heptanol, 6-methyl-2-heptanol, 5-methyl-2-heptanol, 4-methyl-1-cyclohexanemethanol, 1,8-octanediol, 1,5-pentanediol, 5-methyl-3-heptanol, 2-methylcyclohexanol, 1,2-heptanediol, 1,2,6-hexanetriol, 3-cyclohexyl-1-propanol, 6-methyl-1-octanol, 2-nonanol, 3-nonanol, 4-nonanol, 5-nonanol, 2-methyl-2-heptanol, 4-ethylcyclohexanol, 1,3-cyclohexanediol, 1,4-cyclohexanediol, 1,4-cyclohexanedimethanol, cyclooctanol, norbornane-2-methanol, exo-norborneol, 4-(hydroxymethyl)cyclohexanol, 1-decanol, 2-methyl-3-octanol, 1,9-nonanediol, 2,3-dimethyl-2-hexanol and 4-(2-hydroxyethyl)cyclohexanol.

The ketone having from 4 to 10 carbon atoms which does not fall within the scope of the present invention specifically includes, for example, 2-butanone, cyclobutanone, 3-methyl-2-butanone, 3-pentanone, diacetyl, 2-pentanone, pinacoline, cyclopentanone, cyclopropyl methyl ketone, 2-metyl-3-pentanone, 2,4-dimethyl-3-pentanone, 4-methyl-2-pentanone, 3-hexanone, 2,3-pentanedione, acetylacetone, cyclohexanone, 2-hexanone, acetylcyclobutane, 4-heptanone, 1,3-cyclopentanedione, cycloheptanone, dicyclopropyl ketone, ethyl isobutyl ketone, 2-heptanone, 3-heptanone, 2-methyl-3-hexanone, 4-octanone, 3-octanone, 2-octanone, 5-methyl-3-heptanone, 2-methyl-3-heptanone, 6-methyl-2-heptanone, 2-methyl-4-heptanone, cyclooctanone, 2,3-heptanedione, 2,5-dimethyl-3-hexanone, 3-mcthyl-4-heptanone, 4-ethylcyclohexanone, 3,5-dimethylcyclohexanone, 5-methyl-2,3-hexanedione, isoamyl methyl ketone, 3-methyl-2-hexanone, 2,5-dimethylcyclohexanone, 3,4-dimethylcyclohexanone, 2,6-dimethylcyclohexanone, 3,3-dimethylcyclohexanone, dicyclopropyl ketone and 6-methyl-2,4-heptanedione.

The pyridine having from 5 to 10 carbon atoms which does not fall within the scope of the present invention specifically includes, for example, pyridine, 4-picoline, 4-hydroxypyridine, 3-picoline, isoquinoline, 2-picoline, quinoline, 4-ethylpyridine, 3,5-rutidine, 1,6-naphthylidine, 3,4-rutidine, 2,6-rutidine, 2,3-rutidine, 2,5-rutidine, pyrimidine, pyrazine, 3-ethylpyridine, 4-methoXypyridine, 4-pyridinemethanol and 1,5-naphthylidine.

The phenol having from 6 to 10 carbon atoms specifically includes, for example, phenol, hydroquinone, catechol, resorcinol, phloroglucinol, 1-naphthol, 2-naphthol, pyrogallol, 1,6-dihydroxynaphthaiene, 2,7-dihydroxynaphthalene, 2,6-dihydroxynaphthalene, p-cresol, m-cresol, o-cresol, 1,3-dihydroxynaphthalene, 1,4-dihydroxynaphthalene, 2,6-dirnethylphenol, 3,5-ditnethylphenol, 2,3-dimethylphenol, 2,4-dimethylphenol, 2,3-dimethylphenot, methylhydroquinone, 4-methoxyphenol, 4-ethylphenol, 2,4,6-trimethylphenol, 2-ethylphenol and 3-ethylphenol.

The compound represented by formula (1) shown below is described below.

Xⁿ⁺(SCN)ₙ Formula (1)

In formula (1), Xⁿ⁺ represents a counter cation and includes a hydrogen ion, an ammonium ion, a tetraalkylammonium ion and a metal ion. n represents a valence of the counter cation X.

The tetraalkylammonium ion includes, for example, tetramethylammonium ion, tetraethylammonium ion, tetrapropylammonium ion, tetrabutylammonium ion and tetraoctylammonium ion.

The metal ion includes, for example, K⁺, Na⁺, Ca²⁺ and Cu²⁺, n is preferably an integer of 1 to 3.

Specific examples of the compound represented by formula (1) include NaSCN, NH₄SCN, Ca(SCN)₂, Cu(SCN)₂, N(n-Bu)₄(SCN). Of the compounds, NaSCN, NH₄SCN, Ca(SCN)₂ are preferred.

From the standpoint of preventing the precipitation of polyvinyl alcohol in the development processing solution, of the alcohols having from 3 to 10 carbon atoms, alcohols having from 3 to 7 carbon atoms are preferred, alcohols having from 3 to 6 carbon atoms are more preferred, and 1-propanol, 2-propanol, 1-butanol and cyclohexanol are most preferred. Of the ketones having from 4 to 10 carbon atoms, ketones having from 4 to 7 carbon atoms are preferred, ketones having from 4 to 6 carbon atoms are more preferred, and cyclohexanone is most preferred. Of the pyridines having from 5 to 10 carbon atoms, pyridines having from 5 to 7 carbon atoms are preferred, pyridines having from 5 to 6 carbon atoms are more preferred, and pyridine is most preferred. Of the phenols having from 6 to 10 carbon atoms, phenols having from 6 to 7 carbon atoms are preferred, and phenol is most preferred.

From the standpoint of preventing the precipitation of polyvinyl alcohol in the development processing solution, of the specific compounds, phenols having from 6 to 10 carbon atoms and the compounds represented by Formula (1) are preferred, and the compounds represented by formula (1) are most preferred.

The specific compounds may be used in combination of two or more thereof. From the standpoint of the developing property, printing durability and processing property, the content of the specific compound in the developer is from 0.1 to 20% by weight, more preferably from 0.1 to 10% by weight, still more preferably from 0.1 to 5% by weight, particularly preferably from 0.1 to 1.0% by weight, and most preferably from 0.1 to 0.5% by weight. In the case of using two or more kinds of specific compounds, it is preferred that the total amount of two or more specific compounds is in the range described above. The preferred embodiment as for the kind of each specific compound is same as that described above.

### <surfactant>

The development processing solution according to the invention preferably further contains a surfactant (for example, an anionic, nonionic, cationic or amphoteric Surfactant), Of the surfactants, an anionic surfactant is preferably contained. Further, the development processing solution preferably contains both a nonionic surfactant and an anionic surfactant so that an advantage of improving the developing property while maintaining the excellent printing durability is achieved. A mixing ratio of the nonionic surfactant to the anionic surfactant by weight is preferably from 99:1 to 1:99, and more preferably from 99:1 to 20:80.

The anionic surfactant for use in the developer according to the invention is not particularly limited and includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates, Of the compounds, alkylbenzenesulfonic acid salts, alkylnaphthalenesulfonic acid salts and alkyldiphenylether (di)sulfonic acid salts are particularly preferably used.

The cationic surfactant for use in the developer according to the invention is not particularly limited and conventionally known cationic surfactant can be used. Examples of the cationic surfactant include alkylamine salts, quaternary ammonium salts, polyoxyethylene alkyl amine salts and polyethylene polyamine derivatives.

The nonionic surfactant for use in the developer according to the invention is not particularly limited and includes polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol or sorbitan, fatty acid esters of sucrose, alkyl ethers of polyhydric alcohols and fatty acid amides of alkanolamines. Of the compounds, those having an aromatic ring and an ethylene oxide chain are preferred, and an alkyl-substituted or unsubstituted phenol ethylene oxide adduct and an alkyl-substituted or unsubstituted naphthol ethylene oxide adduct are more preferred

The amphoteric surfactant for use in the developer according to the invention is not particularly limited and includes an amine oxide type, for example, alkyldimethylamine oxide, a betaine type, for example, alkyl betaine and an amino acid type, for example, sodium salt of alkylamino fatty acid.

In partiular, an alkyldimethylamine oxide which may have a substituent, an alkyl carboxy betaine which may have a substituent and an alkyl sulfo betaine which may have a substituent are preferably used. Specific examples of the compound used include compounds described, for example, in Paragraph Nos. [0255] to [0278] of JP-A-2008-203359 and Paragraph Nos. [0028] to [0052] of JP-A-2008-276166.

Two or more kinds of the surfactants may be used in combination. The content of the surfactant in the developer is preferably from 0.1 to 20% by weight, more preferably from 1 to 20% by weight, and still more preferably from 1 to 10% by weight. In the case of using two or more kinds of surfactants, it is preferred that the total amount of two or more surfactants is in the range described above (% by weight). In the case of using two or more kinds of surfactants, a combination of a nonionic surfactant and an anionic surfactant is preferred.

### <Other components>

The developer for use in the invention preferably has pH of 2.0 to 11.0. It is preferably an aqueous solution containing water as a main component (containing 60% by weight or more of water). The developer preferably further contains a water-soluble polymer compound. Ordinarily, when the water-soluble polymer compound is incorporated into a developer, polyvinyl alcohol in the protective layer is apt to precipitate. However, the developer according to the invention remarkably exhibits the effect of preventing the precipitation of polyvinyl alcohol in such a case. The pH of the developer is more preferably from 5.0 to 10.7, still more preferably from 6.0 to 10.5, and most preferably from 7.0 to 10.3.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polystyrenesulfonic acid or a salt thereof, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used, For example, as a commercial product, SOYAFIVE (trade name, produced by Fuji Oil Co., Ltd.) is available and various grade products can be used. The soybean polysaccharide preferably used is that having viscosity in a range of 10 to 100 mPa/sec in the 10% by weight aqueous solution thereof.

As the modified starch known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

The weight average molecular weight of the water-soluble polymer compound is preferably in a range of 1,000 to 10,000,000, and more preferably in a range of 2,000 to 1,000,000.

Two or more kinds of the water-soluble polymer compounds may be used in combination. The content of the water-soluble polymer compound in the developer is preferably from 0.1 to 20% by weight, and more preferably from 0.5 to 10% by weight.

Into the developer for use in the invention, a pH buffer agent may further be incorporated.

As the pH buffer agent used in the invention, a pH buffer agent exhibiting a pH buffer function at pH of 2 to 11 is used without particular restriction. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble amine compound and an ion of the water-soluble amine compound exhibits a pH buffer function in the developer to prevent fluctuation of the pH even when the developer is used for a long period of time. As a result, for example, the deterioration of developing property resulting from the fluctuation of pH and the occurrence of development scum are restrained. The combination of a carbonate ion and a hydrogen carbonate ion or the combination of a water-soluble amine compound and an ion of the water-soluble amine compound is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination of (a) a carbonate ion and a hydrogen carbonate ion is adopted as the pH buffer agent, the total amount of the carbonate ion and hydrogen carbonate ion is preferably from 0.05 to 5 mol/l, more preferably from 0.1 to 2 mol/l, particularly preferably from 0.2 to 1 mol/l, in the developer.

In order for a water-soluble amine compound and an ion of the water-soluble amine compound to be present in the developer, a water-soluble amine compound and an ion obtained by neutralizing the amine compound with an acid may be added to the developer or a water-soluble amine compound and an ion of the water-soluble amine compound may be generated by adding a water-soluble amine compound to the developer and then adjusting the pH with an acid. The water-soluble amine compound used is not particularly restricted as long as it is soluble in water. The water-soluble amine compound having a boiling point of 50°C or higher is preferred in order to prevent volatilization when using it. Examples of such an amine compound include triethylamine, dimethylhydroxyethylamine, triethanolamine, morpholine, pyrrolidine, piperidine, 1-methylpiperazine, N-hydraxyethylrnorpholine, 1-pipendineethanol and 4-hydroxy-1-methylpiperidin. The total amount of the water-soluble amine compound and an ion of the water-soluble amine compound is preferably from 0.01 to 5% by weight, more preferably from 0.1 to 2% by weight, in the developer. Examples of the acid for adjusting the pH include hydrochloric acid, hydrobromic acid, perchloric acid, phosphoric acid, sulfuric acid, nitric acid, acetic acid, propionic acid, methanesulfonic acid and p-toluenesulfonic acid.

The developer according to the invention may contain an organic solvent. As the organic solvent to be contained, for example, an aliphatic hydrocarbon (e,g., hexane, heptane, Isopar E, Isopar H, Isobar^{®} G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Examples of the polar solvent include an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer for use in the invention may contain a preservative, a chelating agent, a defaming agent, an organic acid, an inorganic acid, an inorganic salt or the like in addition to the components described above. Specifically, compounds described in Paragraph Nos. [0266] to [0270] of JP-A-2007-206217 are preferably used.

The developer described above can be used as a developer and/or a development replenisher for the exposed lithographic printing plate precursor and it is preferably applied to an automatic processor described hereinafter. In the case of conducting the development processing using an automatic processor, the processing solution becomes fatigued in accordance with the processing amount, and hence the processing ability may be restored using a replenisher or a fresh developer.

The development processing using the developer according to the invention is preferably performed by an automatic processor equipped with a supplying means for the developer and a rubbing member. An automatic processor using a rotating brush roll as the rubbing member is particularly preferred.

Further, the automatic processor is preferably provided with a means for removing the excess developer, for example, a squeeze roller or a drying means, for example, a hot air apparatus, subsequently to the development processing means.

Further, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range of 100 to 500°C. When the temperature is too low, a sufficient effect of strengthening the image may not be obtained, whereas when it is excessively high, problems of deterioration of the support and thermal decomposition of the image area may occur sometimes.

In advance of the above-described development processing, the lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light in a wavelength range of 300 to 450 nm, the lithographic printing plate precursor having an image-recording layer containing a sensitizing dye having an absorption maximum in the wavelength range is used. In case of exposing with light in a wavelength range of 750 to 1,400 nm, the lithographic printing plate precursor containing an infrared absorbing agent which is a sensitizing dye having an absorption maximum in the wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

Now, the lithographic printing plate precursor for use in the invention is described in detail below.

### <Protective layer>

In the lithographic printing plate precursor according to the invention, a protective layer (oxygen-blocking layer) containing polyvinyl alcohol is provided on the image-recording layer in order to prevent diffusion and penetration of oxygen which inhibits the polymerization reaction at the time of exposure. When the lithographic printing plate precursor having a protective layer in which polyvinyl alcohol is used as a main component is combined with the development processing solution described above, the best results can be obtained in the fundamental characteristics, for example, oxygen-blocking property and removability by development.

The polyvinyl alcohol for use in the protective layer may be partially substituted with an ester, an ether or an acetal as long as it contains unsubstituted vinyl alcohol units for achieving the necessary oxygen-blocking property and water solubility. Also, the polyvinyl alcohol may partly have other copolymer component. The polyvinyl alcohol is obtained by hydrolysis of polyvinyl acetate. As specific examples of the polyvinyl alcohol, those having a hydrolysis degree of 71 to 100% and a polymerization repeating unit number of 300 to 2,400 are exemplified. Specific examples of the polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, and more preferably from 30 to 90% by weight.

A known modified polyvinyl alcohol can also be preferably used as polyvinyl alcohol. Particularly, an acid-modified polyvinyl alcohol having a carboxylic acid group or a sulfonic acid group is preferably used. As a component used as a mixture with the polyvinyl alcohol, polyvinyl pyrrolidone or a modified product thereof is preferred from the viewpoint of the oxygen-blocking property and removability by development. The content thereof is ordinarily from 3.5 to 80% by weight, preferably from 10 to 60% by weight, more preferably from 15 to 30% by weight, in the protective layer.

As other component of the protective layer, glycerin, dipropylene glycol or the like can be added in an amount corresponding to several % by weight of the polyvinyl alcohol to provide flexibility to the protective layer. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount corresponding to several % by weight of the polyvinyl alcohol.

Further, it is also preferred to incorporate an inorganic stratiform compound as described in Paragraph Nos. [0018] to [0024] of JP-A-2006-106700 into the protective layer of the lithographic printing plate precursor for the purpose of improving the oxygen-blocking property and property for protecting the surface of image-recording layer. Of the inorganic stratiform compounds, fluorine based swellable synthetic mica, which is a synthetic inorganic stratiform compound, is particularly useful.

The coating amount of the protective layer is preferably in a range of 0.05 to 10 g/m² in terms of the coating amount after drying. When the protective layer contains the inorganic stratiform compound, it is more preferably in a range of 0.1 to 5 g/m², and when the protective layer does not contain the inorganic stratiform compound, it is more preferably in a range of 0.5 to 5 g/m².

### <Image-recording layer>

### (Binder polymer)

The image-recording layer of the lithographic printing plate for use in the invention contains polyvinyl butyral. The term "polyvinyl butyral" as used herein means a polymer synthesized by a reaction (acetalization reaction) of polyvinyl alcohol obtained by partial or full saponification of polyvinyl acetate with butylaldehyde under an acidic condition and includes also a polymer wherein an acid group or the like is introduced, for example, by a method of reacting the remaining hydroxy group of polymer with a compound having the acid group or the like.

As the polyvinyl butyral, polyvinyl butyral having an acid group is preferred because an advantage of improving the developing property while maintaining the printing durability is achieved. A ratio (% by mole) of a repeating unit having an acid group in the total repeating units of polyvinyl butyral is preferably from 1 to 70% from the standpoint of the developing property. Considering good compatibility between the developing property and printing durability, it is more preferably from 1 to 50%, and particularly preferably from 1 to 30%. Examples of the acid group include a carboxylic acid group, a sulfonic acid group, a phosphonic acid group, a phosphoric acid group and a sulfonamido group, and a carboxylic acid group is particularly preferred.

Polyvinyl butyral having an acid group represented by formula (2) shown below is preferably used.

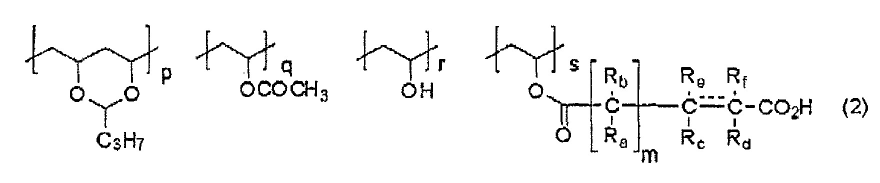

In Formula (2), a ratio of each repeating unit p/q/r/s is preferably in a range from 50 to 78% by mole/from 1 to 5% by mole/from 5 to 28% by mole/from 5 to 20% by mole. Rₐ, R_{b}, R_{c}, R_{d}, Rₑ and R_{f} each independently represents a monovalent substituent which may have a substituent or a single bond, and m represents an integer of 0 to 1. Preferable examples of the substituent represented by any one of Rₐ, R_{b}, R_{c}, R_{d}, Rₑ and R_{f} include a hydrogen atom, an alkyl group which may have a substituent, a halogen atom and an aryl group which may have a substituent. More preferable examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may form a ring structure. The bond between the carbon atom to which R_{c} and R_{c} connect and the carbon atom to which R_{d} and R_{f} connect is a single bond, a double bond or an aromatic double bond and in the case of the double bond or aromatic double bond, R_{c} and R_{d}, Rₑ and R_{f}, Rₑ and R_{f} or R_{c} and R_{d} are connected with each other to from a single bond.

The polyvinyl butyral represented by formula (2) can be obtained, for example, by reacting a compound represented by formula (2') shown below according to a known manner with a hydroxy group of a polymer synthesized by a reaction (acetalization reaction) of polyvinyl alcohol obtained by partial or full saponification of polyvinyl acetate with butylaldehyde under an acidic condition.

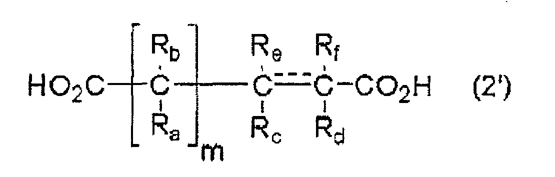

Preferable specific, examples of the repeating unit having a carboxylic acid group include those set forth below.

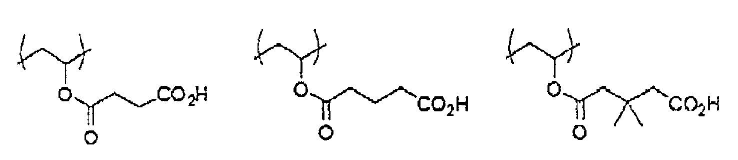

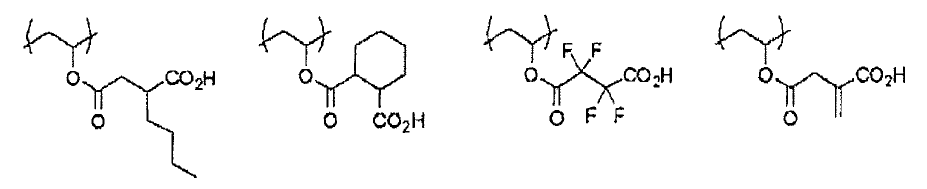

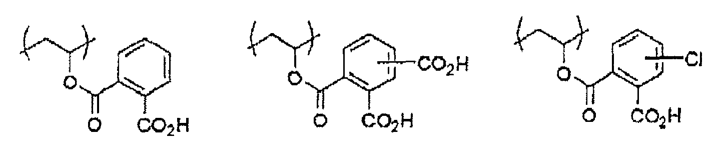

The polyvinyl butyral preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The content of polyvinyl butyral is preferable from 5 to 75% by weight, more preferably from 10 to 70% by weight, still more preferably from 10 to 60% by weight, based on the total solid content of the image-recording layer, from the standpoint of good strength of the image area and good image-forming property.

The total content of the polymerizable compound described hereinafter and the polyvinyl butyral is preferably 80% by weight or less based on the total solid content of the image-recording layer. When it exceeds 80% by weight, decrease in the sensitivity and deterioration in the developing property may be caused sometimes. The total content thereof is more preferably from 35 to 75% by weight.

According to the invention, the image-recording layer may appropriately contain other binder polymer in addition to the polyvinyl butyral, if desires, As the other binder polymer, a polymer capable of holding the components of image-recording layer on a support and capable of being removed with a developer is used. The other binder polymer used includes a (meth)acrylic polymer, a polyurethane, a polyvinyl alcohol, a polyvinyl formal, a polyamide, a polyester and an epoxy resin. Particularly, a (meth)acrylic polymer is preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (ineth)acrylamidc derivative. The term "polyurethane" as used herein means a polymer prepared by condensation reaction of a compound having two or more isocyanate groups and a compound having two or more hydroxy groups,

One preferred example of the other binder polymer according to the invention is a copolymer containing a repeating unit having an acid group, Examples of the acid group include a carboxylic acid group, a sulfonic acid group, a phosphonic acid group, a phosphoric acid group and a sulfonamido group, and a carboxylic acid group is particularly preferred. As the repeating unit, a repeating unit derived from (meth)acrylic acid or a repeating unit represented by formula (I) shown below is preferably used.

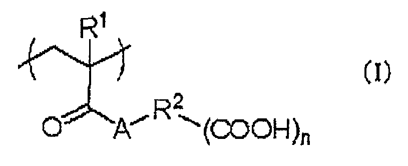

In Formula (I), R¹ represents a hydrogen atom or a methyl group, R² represents a single bond or an n+1 valent connecting group, A represents an oxygen atom or -NR³-, wherein R³ represents a hydrogen atom or a monovalent hydrocarbon group having from 1 to 10 carbon atoms, and n represents an integer of 1 to 5.

The connecting group represented by R² in formula (I) is constructed from a carbon atom, a hydrogen atom, an oxygen atom, a nitrogen atom, a sulfur atom and a halogen atom, and preferably contains from I to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and most preferably a hydrogen atom or a methyl group. n is preferably from 1 to 3, more preferably 1 or 2, and most preferably 1.

A ratio (% by mole) of the repeating unit having an acid group in the total repeating units of the other binder polymer is preferably from 1 to 70% from the standpoint of the developing property. Considering good compatibility between the developing property and printing durability, it is more preferably from 1 to 50%, and particularly preferably from 1 to 30%.

Moreover, when the other binder polymer has an acid group, the acid group may be neutralized with a basic compound. In such a case, it is particularly preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the other binder polymer for use in the invention further contains a crosslinkable group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is referred. The ethylenically unsaturated bond group preferably includes a styryl group, a (meth)acryloyl group and an allyl group.

In the other binder polymer, for example, a free radical (a polymerization initiating radical or a propagating radical in the process of polymerization of the polymerizable compound) is added to the crosslinkable group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the other binder polymer is preferably from 0.01 to 10.0 mmol, more preferably from 0.05 to 5.0 mmol, and most preferably from 0.1 to 2.0 mmol, per g of the other binder polymer.

The other binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The other binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

In the case of using the other binder polymer, the total content of the other binder polymer and the polyvinyl butyral is preferably from 5 to 75% by weight, more preferably from 10 to 70% by weight, still more preferable from 10 to 60% by weight, based on the total solid content of the image-recording layer, from the standpoint of good strength of the image area and good image-forming property.

The total content of the polymerizable compound described hereinafter, the other binder polymer and the polyvinyl butyral is preferably 80% by weight or less based on the total solid content of the image-recording layer. When it exceeds 80% by weight, decrease in the sensitivity and deterioration in the developing property may be caused sometimes. The total content thereof is more preferably from 35 to 75% by weight.

In the case of using the other binder polymer, a weight ratio of the polyvinyl butyral to the other binder polymer (polyvinyl butyral/other binder polymer) is preferably 0.01 or more, more preferably 0.1 or more, and most preferably 1.0 of more. The weight ratio is preferably 100 or less, more preferably 50 or less, and most preferably 20 or less.

According to the invention, by controlling a ratio of the polymerizable compound to the total amount of the other binder polymer and the polyvinyl butyral contained in the image-recording layer of the lithographic printing plate precursor, the permeability of developer into the image-recording layer more increases and the developing property is further improved, Specifically, a weight ration of the polymerizable compound to the binder polymer (total amount of the polyvinyl butyral and the other binder polymer) in the image-recording layer is preferably 1,2 or more, more preferably from 1.25 to 4.5, and most preferably from 2 to 4.

### (Polymerization initiator)

The image-recording layer of the lithographic printing plate precursor for use in the invention contains a polymerization initiator (hereinafter, also referred to as an initiator compound). In the invention, a radical polymerization initiator is preferably used.

As the initiator compound according to the invention, initiator compounds known to those skilled in the art can be used without limitation. Specifically, the initiator compound includes, for example, a trihalomethyl compound, a carbonyl compound, an organic peroxide an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferred, and the hexaarylbiimidazole compound is particularly preferred. The polymerization initiators may be appropriately used in combination of two or more thereof.

The hexaarylbiimidazole compound includes, for example, lophine dimers described in JP-B-45-37377 (the term "JP-B" as used herein means an "examined Japanese patent publication") and JP-B-44-86516, specifically, 2,2'-his(o-clolorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4.4'.5,5'-tetraphenylbiimidazole and 2,2'-bis(o-trifluoromethylphenyul)-4,4'5,5'-tetraphenylbiimidazole.

The hexaarylbiimidazole compound is particularly preferably used together with a sensitizing dye having an absorption maximum in a wavelength range of 300 to 450 nm described hereinafter.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with the infrared absorbing agent having an absorption maximum in a wavelength range of 750 to 1,400 nm.

In addition, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the image-recording layer according to the invention is preferably from 0.01 to 20% by weight, more preferably from 0.1 to 15% by weight, still more preferably from 1.0 to 10% by weight, based on the total solid content of the image-recording layer.

### (Polymerizable compound)

The polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-36-17654, JP-B-62-39417 and JP-B-62-39418 are preferably used.

Also, a photo-oxidizable polymerizable compound described in JP-T-2007-506125 (the term "JP-T" as used herein means a published Japanese translation of a PCT patent application) is preferred and a polymerizable compound containing at least one urea group and/or tertiary amino group is particularly preferred. Specifically, the compound set forth below is exemplified.

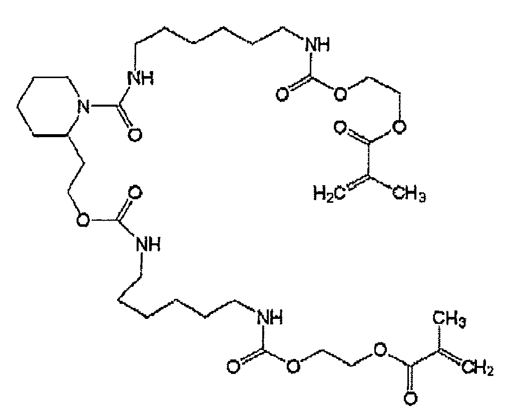

Details of the method of using the polymerizable compound, for example, selection of the structure, individual or combination use or an amount added, can be appropriately determined in accordance with the characteristic design of the final lithographic printing plate precursor.

The polymerizable compound is used preferably in a range of 5 to 75% by weight, more preferably in a range of 25 to 70% by weight, particularly preferably in a range of 30 to 60% by weight, based on the total solid content of the image-recording layer.

### (Sensitizing dye)

The image-recording layer of the lithographic printing plate precursor according to the invention preferably contains a sensitizing dye. The sensitizing dye can be used without particular limitation as far as it absorbs light at the image exposure to form the excited state and provides energy to the polymerization initiator described hereinbefore with electron transfer, energy transfer or heat generation thereby improving the polymerization initiation function. Particularly, a sensitizing dye having an absorption maximum in a wavelength range of 300 to 450 nm or 750 to 1,400 nm is preferably used.

Examples of the sensitizing dye having an absorption maximum in a wavelength range of 300 to 450 nm include merocyanine dyes, benzopyranes, coumarins, aromatic ketones and anthracenes.

Of the sensitizing dyes having an absorption maximum in a wavelength range of 300 to 450 nm, a dye represented by formula (IX) shown below is more preferred in view of high sensitivity.

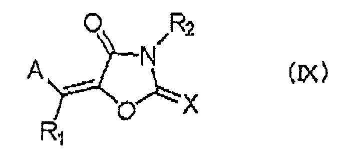

In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom. Specific examples of the monovalent non-metallic atomic group represented by any one of R₁, R₂ and R₃ preferably include groups described in Paragraph Nos. [0035] to [0043] of JP-A-2007-58170.

Now, A in formula (IX) is described below. A represents an aromatic cyclic group which may have a substituent or a heterocyclic group which may have a substituent. Specific examples of the aromatic cyclic group which may have a substituent and heterocyclic group which may have a substituent are same as those described for the substituted or unsubstituted aryl group and substituted or unsubstituted aromatic heterocyclic residue represented by any one of R₁, R₂ and R₃ in formula (IX), respectively.

Specific examples of the sensitizing dye used preferably include compounds described in Paragraph Nos. [0047] to [0053] of JP-A-2007-58170.

Further, a sensitizing dye represented by formula (V) or (VI) shown below can also be used.

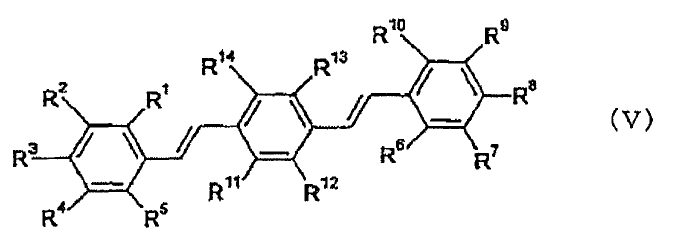

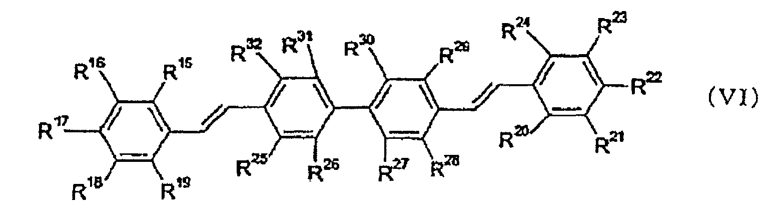

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Further, sensing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range of 750 to 1,400 (hereinafter, also referred to as an "infrared absorbing agent") preferably used in the invention is described in detail below. The infrared absorbing agent used is preferably a dye or pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, a cyanine dye represented by formula (a) shown below is exemplified,

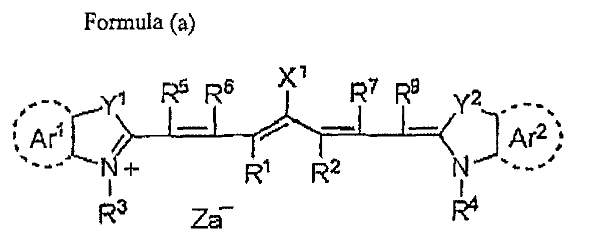

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

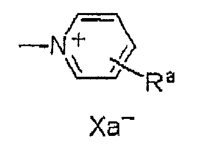

R¹ and R² each independently represents a hydrocarbon group having from 1 to 12 carbon atoms. In view of the preservation stability of a coating solution for image-recording layer, it is preferred that R¹ and R² each represents a hydrocarbon group having two or more carbon atoms. It is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-recording layer.

Specific examples of the cyanine dye represented by formula (a), which can be preferably used in the invention, include those descried in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Ovou Gijutsu (Newest Application on Technologies for Pigments), CMC Publishing Co., Ltd. (1986) and Insatsu Ink Gijutsu (Printing Ink Technology). CMC Publishing Co., Ltd. (1984).

The amount of the sensitizing dye added is preferably from 0.05 to 30 parts by weight, more preferably from 0.1 to 20 parts by weight, most preferably from 0.2 to 10 parts by weight, per 100 parts by weight of the total solid content of the image-recording layer.

### <Other components of image-recording layer>

The image-recording layer preferably further contains a chain transfer agent. As the chain transfer agent, for example, compounds having SH, PH, SiH or GeH in their molecules are used. The compound donates hydrogen to a low active radical species to generate a radical or is oxidized and deprotonized to generate a radical.

In particular, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used as the chain transfer agent in the image-recording layer according to the invention. Specific examples of the thiol compound include those described in Paragraph Nos. [0212] to [0216] of JP-A-2008-276155.

Into the image-recording layer according to the invention, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the image-recording layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer or chain transfer agent for increasing sensitivity, and a plasticizer for improving plasticity. As the additives, known compounds are used and, for example, compounds described in Paragraph Nos. [0161] to [0215] of JP-A-2007-206217 are used.

### <Formation of image-recording layer>

The image-recording layer according to the invention is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ -butyrolactone, but the invention should not be construed as being limited thereto. The solvents may be used individually or as a mixture. The solid content concentration of the coating solution is preferably from 1 to 50% by weight.

The coating amount (solid content) of the image-recording layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### [Support]

The support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of the support is preferably from 0.10 to 1.2 µm. In the range described above, good adhesion property to the image-recording layer, good printing durability and good resistance to stain are achieved.

The color density of the support is preferably from 0.15 to 0.65 in terms of the reflection density value. In the range described above, good image-forming property by prevention of halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### (Hydrophilizing treatment for support and undercoat layer)

As for the lithographic printing plate precursor according to the invention, in order to increase hydrophilicity of the non-image area and to prevent printing stain, it is preferred to conduct hydrophilizing treatment for the surface of support or to provide an undercoat layer between the support and the image-recording layer.

The hydrophilizing treatment for the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. A method of immersion treatment in an aqueous polyvinylphosphonic acid solution is preferably used.

As the undercoat layer, an undercoat layer containing a compound having an acid group, for example, a phosphoric acid group, a phosphoric acid group or a sulfonic acid group is preferably used. The compound preferably further has a polymerizable group in order to increase the adhesion property to the image-recording layer. Also, a compound having a hydrophilicity-imparting group, for example, an ethylene oxide group is preferred,

These compounds may be low molecular weight compounds or polymers. For example, a silane coupling agent having an addition-polymerizable ethylenic double bond reactive group described in JP-A-10-282679 and a phosphorus compound having an ethylenic double bond reactive group described in JP-A-2-304441 are preferably exemplified.

As the most preferable undercoat layer, an undercoat layer containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 is exemplified.

A coating amount (solid content) of the undercoat layer is preferably from 0.1 to 100 mg/m², and more preferably from 1 to 30 mg/m²,

### <Backcoat layer>

A backcoat layer can be provided on the back surface of the support, if desired, after applying the surface treatment to the support or forming the undercoat layer on the support. The backcoat layer preferably includes, for example, a coating layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Example]

### Examples 1 to 7, 18 to 21, 25 to 30, 34 and 35, Reference Examples 8 to 17, 22 to 24 and 31 to 33 and Comparative Examples 1 to 9

Hereinafter ratio of a repeating unit as for polymer compound is a molar ratio.

### [Preparation of Lithographic printing plate precursors (1), (2) and (R-1) to (R-3)]

### <Preparation of Support>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate thus-treated was subjected to an anodizing treatment under condition of current density of 10 A/dm² and voltage of 15 V in an aqueous 15% by weight sulfuric acid solution at 25°C for one minute and then subjected to a hydrophilization treatment using an aqueous 1% by weight polyvinyl phosphonic acid solution at 75°C to prepare a support. The surface roughness of the support was measured and found to be 0.44 µm (Ra indication according to JIS B0601).

### <Formation of Image-recording layer 1>

Coating solution (1) for image-recording layer having the composition shown below was coated on the support using a bar and dried in an oven at 90°C for 60 seconds to form Image-recording 1 layer having a dry coating amount of 1.3 g/m².

### <Coating solution (1) for image-fecording layer>

| | |
|---|---|
| • Binder Polymer (1) shown below | 0.04 g |
| (weight average molecular weight: 50,000) | |
| • Binder Polymer (2) shown below | |
| (weight average molecular weight: 80,000) | 0.30 g |
| • Polymerizable Compound (1) shown below | 0.17 g |
| (PLEX^{®} 6661-O, produced by Degussa Japan Co. Ltd.) | |
| • Polymerizable Compound (2) shown below | 0.51 g |
| • Sensitizing Dye (1) shown below | 0.03 g |
| • Sensitizing Dye (2) shown below | 0.015 g |
| • Sensitizing Dye (3) shown below | 0.015 g |
| • Polymerization Initiator (1) shown above | 0.13 g |
| • Chain Transfer Agent: Mercaptobenzothiazole | 0.01 g |
| • Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| • Thermal polymerization inhibitor | 0.01 g |
| N-nitrosophenylhydroxylamine aluminum salt | |
| • Fluorine-Based Surfactant (1) shown below | 0.001 g |
| • 1-Methoxy-2-propanol | 3.5 g |
| • Methyl ethyl ketone | 8.0 g |

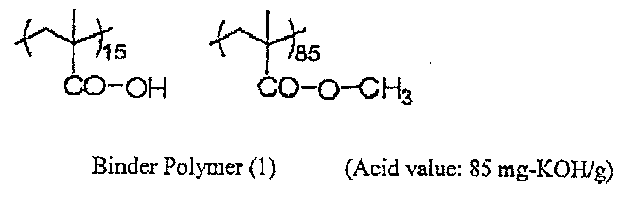

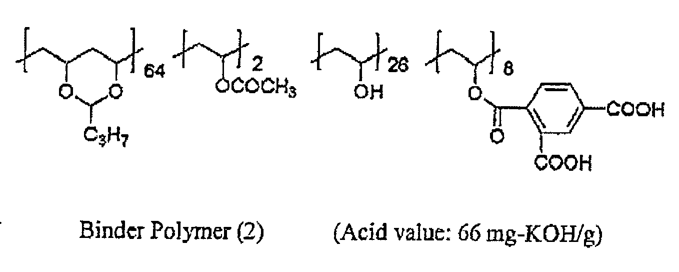

### [A mixture of the following isomers]

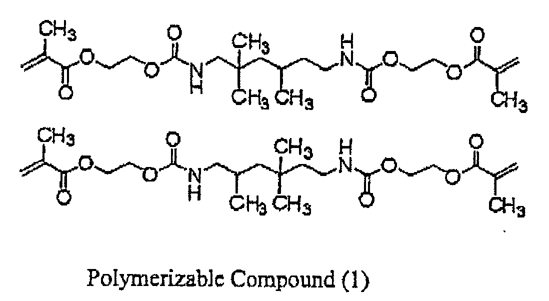

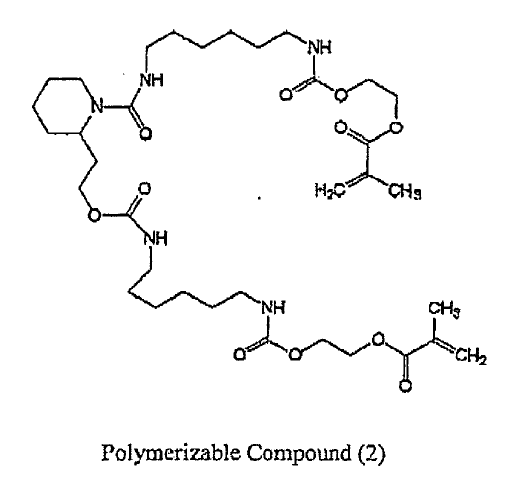

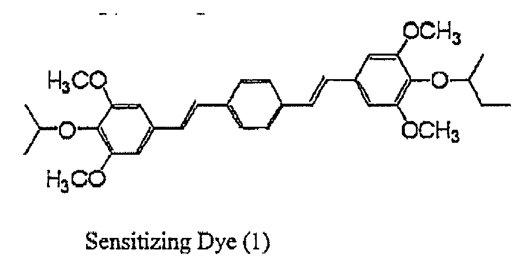

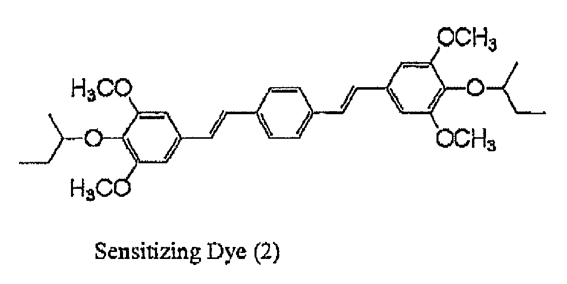

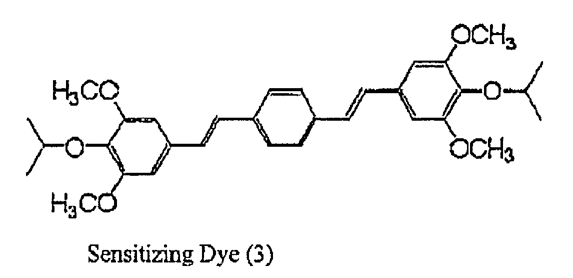

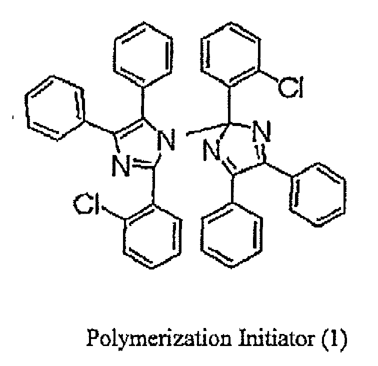

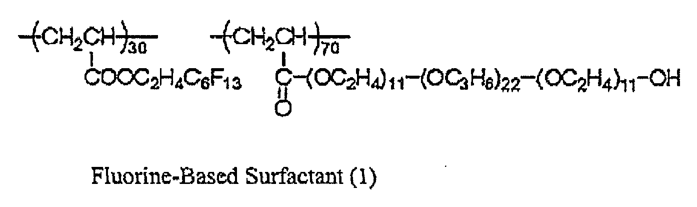

### <Formation of Protective layer 1>

Coating solution (1) for protective layer having the composition shown below was coated on the image-recording layer using a bar so as to have a dry coating amount of 1.2 g/m² and dried at 125°C for 70 seconds to from Protective layer 1, thereby preparing Lithographic printing plate precursor (1).

### <Coating solution (1) for protective layer>

| | |
|---|---|
| • PVA-205 | 0.658 g |
| [partially hydrolyzed polyvinyl alcohol, produced by Kuraray Co.,Ltd. (saponification degree: 86.5 to 89.5% by mole; viscosity: 4.6 to 5.4 mPa·s in a 4% by weight aqueous solution at 20°C)] | |
| • PVA-105 | 0.142 g |
| [fully hydrolyzed polyvinyl alcohol, produced by Kuraray Co., Ltd. (saponification | |
| degree: 98.0 to 99.0% by mole; viscosity: 5.2 to 6.0 mPs·s in a 4% | |
| by weight aqueous solution at 20°C)] | |
| • Vinyl pyrrolidone/vinyl acetate (1/1) copolymer | |
| (weight average molecular weight: 70,000) | 0.001 g |
| • Surfactant | 0.002 g |
| (EMALEX^{®} 710, produced by Nihon Emulsion Co., Ltd.) | |
| - Water | 13 g |

### <Formation of Image-recording layer 2>

Image-recording layer 2 was formed in the same manner as in Lithographic printing plate precursor (1) except for changing Coating solution (1) for image-recording layer to Coating solution (2) for image-recording layer shown below. Then, Protective layer 1 was formed using Coating solution (1) for protective layer in the same manner as in Lithographic printing plate precursor (1), thereby preparing Lithographic printing plate precursor (2).

### <Coating solution (2) for image-recording layer>

| | |
|---|---|
| • Binder Polymer (1) shown above | 0.04 g |
| (weight average molecular weight: 50,000) | |
| • Binder Polymer (3) shown below | 0.30 g |
| (weight average molecular weight: 80,000) | |
| • Polymerizable Compound (1) shown above | 0.17 g |
| (PLEX^{®} 6661-O, produced by Degussa Japan Co. Ltd.) | |
| • Polymerizable Compound (2) shown above | 0.51 g |
| • Sensitizing Dye (1) shown abave | 0.03 g |
| • Sensitizing Dye (2) shown above | 0.015 g |
| • Sensitizing Dye (3) shown above | 0.015 g |
| • Polymerization Initiator (1) shown above | 0.13 g |
| • Chain Transfer Anent : Mercaptobenzothiazole | 0.01 g |
| • Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| - Thermal polymerization inhibitor | 0.01 g |
| N-nitrosophenylhydroxylamine aluminum salt | |
| • Fluorine-Based Surfactant (1) shown above | 0.001 g |
| • 1-Methoxy-2-propanol | 3.5 g |
| • Methyl ethyl ketone | 8.0 g |

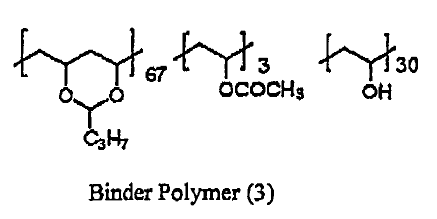

### <Formation of Image-recording layer 3>

Image-recording layer 3 was formed in the same manner as in Lithographic printing plate precursor (1) except for changing Coating solution (1) for image-recording layer to Coating solution (3) for image-recording layer shown below. Then, Protective layer 1 was formed using Coating solution (1) for protective layer in the same manner as in Lithographic printing plate precursor (1), thereby preparing Lithographic printing plate precursor (R-1) for comparison.

### <Coating solution (3) for image-recording layer>

| | |
|---|---|
| • Binder Polymer (1) shown above | 0.34 g |
| (weight average molecular weight: 50,000) | |
| • Polymerizable Compound (1) shown above | 0.17 g |
| (PLEX^{®} 6661-O, produced by Degussa Japan Co. Ltd.) | |
| • Polymerizable Compound (2) shown above | 0.51 g |
| • Sensitizing Dye (1) shown above | 0.03 g |
| • Sensitizing Dye (2) shown above | 0.015 g |
| • Sensitizing Dye (3) shown above | 0.015 g |
| • Polymerization Initiator (1) shown above | 0.13 g |
| • Chain Transfer Agent: Mercaptobenzothiazole | 0.01 g |
| • Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| • Thermal polymerization inhibitor | 0.01 g |
| N-nitrosophenylhydroxylamine aluminum salt | |
| • Fluorine-Based Surfactant (1) shown above | 0.001 g |
| • 1-Methoxy-2-propanol | 3.5 g |
| • Methyl methyl ketone | 8.0 g |

In the same manner as in Lithographic printing plate precursor (R-1) for comparison, Image-recording layer 3 was formed and then Protective layer 2 was formed using Coating solution (2) for protective layer shown below in place of Protective layer 1, thereby preparing Lithographic printing plate precursor (R-2) for comparison,

### <Coating solution (2) for protective layer>

| | |
|---|---|
| • Polyvinylpyrrolidone K30 | 0.800 g |
| (produced by Wako Pure Chemical Industries, Ltd., weight average molecular weight: 400,000) | |
| • Surfactant (EMALEX^{®} 710, produced by Nihon Emulsion Co., Ltd.) | 0.002 g |
| • Water | 13 g |

In the same manner as in Lithographic printing plate precursor (1), Image-recording layer 1 was formed and then Protective layer 2 was formed using Coating solution (2) for protective layer shown above in place of Protective layer 1, thereby preparing Lithographic printing plate precursor (R-3) for comparison.

### (1) Exposure, Development and Printing

The lithographic printing plate precursor was subjected to image exposure by a violet semiconductor laser plate setter Vx9600 (having InGaN semiconductor laser: emission: 405 nm ± 10 nm/output: 30 mW) produced by FUJIFILM Electronic Imaging, Ltd. As for the image, halftone dots of 50% were drawn using an FM screen (TAFFETA^{®} 20, produced by FUJIFILM Corp.) in a plate surface exposure amount of 0.05 mJ/cm² and at resolution of 2,438 dpi.

The exposed lithographic printing plate precursor was then subjected to development processing in an automatic development processor having a structure shown in Fig. 1 using each of Developers (1) to (27) and (R-1) to (R-6) having the composition shown below at transporting speed so as to have pre-heating time of 10 seconds at 100°C and immersion time (developing time) in the developer of 20 seconds.

The automatic development processor comprises a pre-heating unit 4 for performing heat treatment of the whole surface of a lithographic printing plate precursor (hereinafter, also referred to as a "PS plate") 1 before development, a developing unit 6 for developing the PS plate 1 and a drying unit 10 for drying the PS plate 1 after development. The imagewise exposed PS plate 1 is carried in through a carrying-in slot into the pre-heating unit 4 by carrying-in rollers 12 and subjected to heat treatment in a heating chamber 5. In the heating chamber 5, skewer rollers 14 are provided. In the heating chamber 5, a heating means (not shown), for example, a heat generating means or a hot air supplying means is also provided. Then, the PS plate 1 is transferred into the developing unit 6 by transport rollers 16. In a developing tank 20 of the developing unit 6, transport rollers 22, a brush roller 24 and squeeze rollers 26 are provided in order from the upstream side in the transporting direction of PS plate 1 and backup rollers 28 are disposed in appropriate positions therebetween. The PS plate 1 is immersed in the developer while being transported by the transport rollers 22 and the non-image area of PS plate 1 is removed by rotation of the brush roller 24 to conduct development processing. The PS plate 1 subjected to the development processing is transported into the drying unit 10 by the squeeze rollers (carrying-out rollers) 26. In the drying unit 10, a guide roller 36 and a pair of skewer rollers 38 are disposed in order from the upstream side in the transporting direction. In the drying unit 10, a drying means (not shown), for example, a hot air supply means or a heat generating means is also provided. A discharge slot is provided in the drying unit 10 and the PS plate 1 dried by the drying means is discharged through the discharge slot, whereby the automatic development processing for the PS plate is completed.

The automatic development processor used in the example had one brush roller having an outer diameter of 50 mm and being implanted with fiber of polybutylene terephthalate (bristle diameter: 200 µm, bristle length: 17 mm), and the brush roller was rotated at 200 rpm (peripheral velocity at the tip of brush: 0.52 m/sec) in the same direction as the transporting direction of the lithographic printing plate precursor. The temperature of the developer was 30°C. After the development processing, the lithographic printing plate was dried in the drying unit. The drying temperature was 80°C.

The lithographic printing plate obtained by the development processing was mounted on a printing machine (SOR-M^{®}, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G^{®} (N) black ink (produced by Dainippon Ink & Chemicals, Inc.).

### <Developers (1) to (27) and Developer (R-1) to (R-6) for comparison

| | |
|---|---|
| Water | 88.6g |
| Specific compound shown in Table 1 | X g (shown in Table 1) |
| Nonionic Surfactant (W-1) shown below | Y1 g (shown in Table 1) |
| Nonionic Surfactant (W-2) shown below | Y2 g (shown in Table 1) |
| Nonionic Surfactant (W-3) shown below | Y3 g (shown in Table 1) |
| Anionic Surfactant (W-4) shown below | Y4 g (shown in Table 1) |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Water-Soluble Polymer Compound (H-1) shown below | Y5 g (shown in Table 1) |

| | |
|---|---|
| * pH was adjusted to 7.0 by adding phosphoric acid. | |

Nonionic Surfactants (W-1), (W-2) and (W-3), Anionic Surfactant (W-4) and Water-Sotuble Polymer Compound (H-1) in Table 1 are shown below. Nonionic Surfactants (W-1) and (W-2) are mixtures of compounds having different 1 and m values in the ranges shown below, respectively.

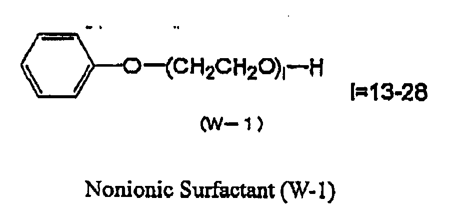

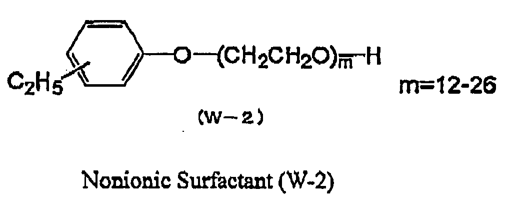

Nonionic Surfactant (W-3): EMALEX^{®} 710 (polyoxyethylene lauryl ether), produced by Nihon Emulsion Co., Ltd.)

Anionic Surfactant (W-4): ELEMINOL^{®} MON-2 (mixture of disodium alkyldiphenyl ether disulfonate and sodium alkyldiphenyl ether monosulfonate, produced by Sanyo Chemical Industries, Ltd., 47 wt% aqueous solution)

H-1: Polystyrenesulfonic acid (VERSA^{®} TL77 (30% solution), produced by Alco Chemical Inc.)

### (2) Evaluation

### < Developing property >

The lithographic printing plate precursor was subjected to the image exposure and development processing as described above. The non-image area of the lithographic printing plate obtained by the development processing was visually observed and the residue of the image-recording layer was evaluated according to the criteria described below.
A: Good developing property where the residue of image-recording layer was not present at all (even when carefully observed, the residue of image-recording layer was not confirmed).
B: Good developing property where the residue of image-recording layer was almost not present (when carefully observed, the residue of image-recording layer was confirmed).
C: The residue of image-recording layer was confirmed but was acceptable.
D: The image-recording layer remained to cause development failure.

### <Printing image-forming property>

The lithographic printing plate was subjected to the printing as described above. On the 1,000^{th} printed material, stain in the non-image area and unevenness (unevenness of ink density) in the halftone dot image were evaluated according to the criteria described below.

### (Stain)

A: Good condition where the ink stain was not present at all in the non-image area (even when carefully observed, the ink stain was not confirmed).
B: Good condition where the ink stain was almost not present in the non-image area (when carefully observed, the ink stain was confirmed).
C: The ink stain was confirmed in the non-image area but was acceptable.
D: The ink stain was present in the non-image area.

### (Unevenness)

A: Unevenness of ink density in the halftone dot image was not present at all to provide clear image (even when carefully observed, the unevenness of ink density was not confirmed).
B: Unevenness of ink density in the halftone dot image was almost not present to provide clear image (when carefully observed, the unevenness of ink density was confirmed).
C: Unevenness of ink density in the halftone dot image was confirmed but was acceptable.
D: Unevenness of ink density in the halftone dot image was present.

### <processing property>

After the lithographic printing plate precursor was subjected to development processing using the automatic development processor as described above in an amount of 500 m², the generation of scum adhered on the tank wall of the automatic development processor was observed and evaluated according to the criteria described below.
A: The generation of scum was not observed at all and the developer was clear (even when carefully observed, the scum was not confirmed).
B: The generation of scum was almost not observed and the developer was clear (when carefully observed, the scum was confirmed).
C: The generation of scum was confirmed but was acceptable.
D: The generation of scum was severe and was not acceptable.

### <Printing durability>

As increase in the number of printed materials, the image of the image-recording layer formed on the lithographic printing plate was gradually abraded to cause decrease in the ink receptivity, resulting in decrease in ink density of the image on a printing paper. A number of printed materials obtained until the ink density (reflection density) decreased by 0.1 from that at the initiation of printing was determined to evaluate the printing durability.

**TABLE 1**

| Developer | Specific Compound | | | Surfactant (g) | | | | Water-Soluble Polymer Compound (g) |
|---|---|---|---|---|---|---|---|---|
| | Kind | Weight (X g) | % by Weight" | W-1 (weight Y1 g) | W-2 (weight Y2 g) | W-3 (weight: Y3 g) | W-4 (weight: Y4 g) | H-1 (weight: Y5 g) |
| (1) | NaSCN | 25.0 | 20.0 | 2.4 | 2.4 | 1.0 | 0.0 | 1.0 |
| (2) | NaSCN | 10.0 | 9.1 | 2.4 | 2.4 | 1.0 | 0.0 | 1.0 |
| (3) | NaSCN | 5.0 | 4.8 | 2.4 | 2.4 | 1.0 | 0.0 | 1.0 |
| (4) | NaSCN | 1.0 | 1.0 | 2.4 | 2.4 | 1.0 | 0.0 | 1.0 |
| (5) | NaSCN | 0.4 | 0.4 | 2.4 | 2.4 | 1.0 | 0.0 | 1.0 |
| (6) | Ca(SCN)₂ | 1.0 | 1.0 | 2.4 | 2.4 | 1.0 | 0.0 | 1.0 |
| (7) | NH₄SCN | 1.0 | 1.0 | 2.4 | 2.4 | 1.0 | 0.0 | 1.0 |
| (8) | 2-Propanol | 1.0 | 1.0 | 2.4 | 2.4 | 1.0 | 0.0 | 1.0 |
| (9) | Cyclohexanol | 1.0 | 1.0 | 2.4 | 2.4 | 1.0 | 0.0 | 1.0 |
| (10) | 1-Octanol | 1.0 | 1.0 | 2.4 | 2.4 | 1.0 | 0.0 | 1.0 |
| (11) | 1-Decanol Cyclohexan one | 1.0 | 1.0 | 2.4 | 2.4 | 1.0 | 0.0 | 1.0 |
| (13) | 2-Butanone | 1.0 | 1.0 | 2.4 | 2.4 | 1.0 | 0.0 | 1.0 |
| (14) | 2-hexanone | 1.0 | 1.0 | 2.4 | 2.4 | 1.0 | 0.0 | 1.0 |
| (15) | 4-Octanone | 1.0 | 1.0 | 2.4 | 2.4 | 1.0 | 0.0 | 1.0 |
| (16) | Pyridine | 1.0 | 1.0 | 2.4 | 2.4 | 1.0 | 0.0 | 1.0 |
| (17) | Quinoline | 1.0 | 1.0 | 2.4 | 2.4 | 1.0 | 0.0 | 1.0 |
| (18) | Phenol | 1.0 | 1.0 | 2.4 | 2.4 | 1.0 | 0.0 | 1.0 |
| (19) | 1-Naphthol | 1.0 | 1.0 | 2.4 | 2.4 | 1.0 | 0.0 | 1.0 |
| (20) | NaSCN | 1.0 | 1.0 | 0.0 | 0.0 | 0.0 | 5.8 | 1.0 |
| (21) | NaSCN | 1.0 | 1.0 | 2.4 | 0.0 | 1.0 | 2.4 | 1.0 |
| (22) | 2-Propanol | 1.0 | 1.0 | 2.4 | 0.0 | 1.0 | 2.4 | 1.0 |
| (23) | Cyclohexan one | 1.0 | 1.0 | 2.4 | 0.0 | 1.0 | 2.4 | 1.0 |
| (24) | Pyridine | 1.0 | 1.0 | 2.4 | 0.0 | 1.0 | 2.4 | 1.0 |
| (25) | Phenol | 1.0 | 1.0 | 2.4 | 0.0 | 1.0 | 2.4 | 1.0 |
| (26) | NaSCN | 1.0 | 1.0 | 0.0 | 0.0 | 0.0 | 0.0 | 1.0 |
| (27) | NaSCN | 1.0 | 1.0 | 2.4 | 2.4 | 1.0 | 0.0 | 0.0 |
| (R-1) | None | | | 2.4 | 2.4 | 1.0 | 0.0 | 1.0 |
| (R-2) | Methanol | 1.0 | 1.0 | 2.4 | 2.4 | 1.0 | 0.0 | 1.0 |
| (R-3) | Acetone | 1.0 | 1.0 | 2.4 | 2.4 | 1.0 | 0.0 | 1.0 |
| (R-4) | NaCl | 1.0 | 1.0 | 2.4 | 2.4 | 1.0 | 0.0 | 1.0 |
| (R-5) | NaSCN | 30.0 | 23.0 | 2.4 | 2.4 | 1.0 | 0.0 | 1.0 |
| (R-6) | None | | | 0.0 | 0.0 | 0.0 | 0.0 | 1.0 |

| | | | | | | | | |
|---|---|---|---|---|---|---|---|---|
| * Content ratio of the specific compound in the developer | | | | | | | | |

**TABLE 2**

| Example | Lithographic Printing Plate Precursor | Developer | Evaluation | | | | |
|---|---|---|---|---|---|---|---|
| | | | Developing Property | Stain in Non-image Area | Unevenness of Halftone Dot Image | Processing Property | Printing Curability |
| Example1 | (1) | (1) | A | B | C | A | 6.5 |
| Example 2 | (1) | (2) | A | B | C | A | 7.0 |
| Example 3 | (1) | (3) | A | B | C | A | 8.0 |
| Example 4 | (1) | (4) | A | B | B | A | 9.0 |
| Example 5 | (1) | (5) | A | B | A | A | 10.0 |
| Example 6 | (1) | (6) | A | B | B | A | 9.0 |
| Example 7 | (1) | (7) | A | B | B | A | 9.0 |
| Example 8* | (1) | (8) | B | B | B | B | 8.0 |
| Example 9* | (1) | (9) | B | B | B | B | 8.0 |
| Example 10* | (1) | (10) | B | B | B | | 8.0 |
| Example 11* | (1) | (11) | C | B | B | C | 7.0 |
| Example 12* | (1) | (12) | B | B | B | A | 8.0 |
| Example 13* | (1) | (13) | B | B | B | A | 8.0 |
| Example 14* | (1) | (14) | C | B | B | B | 8.0 |
| Example 15* | (1) | (15) | B | B | B | B | 8.0 |
| Example 16* | (1) | (16) | B | B | B | C | 8.0 |
| Example 17* | (1) | (17) | C | B | B | C | 8.0 |
| Example 18 | (1) | (18) | C | B | B | B | 8.0 |
| Example 19 | (1) | (19) | C | B | B | C | 8.0 |
| Example 20 | (1) | (20) | B | C | B | B | 10.0 |
| Example 21 | (1) | (21) | A | B | B | A | 10.0 |
| Example 22* | (1) | (22) | B | B | B | B | 9.0 |
| Example 23* | (1) | (23) | B | B | B | A | 9.0 |
| Example 24* | (1) | (24) | B | B | B | C | 9.0 |
| Example 25 | (1) | (25) | C | B | B | B | 9.0 |
| Example 26 | (1) | (26) | C | C | C | C | 10.0 |
| Example 27 | (1) | (27) | A | C | B | A | 9.0 |
| Example 28 | (2) | (4) | C | B | B | B | 9.5 |
| Example 29 | (2) | (20) | C | C | B | | 10.0 |
| Example 30 | (2) | (21) | C | B | B | C | 10.0 |
| Example 31* | (2) | (22) | C | B | B | C | 9.0 |
| Example 32* | (2) | (23) | C | B | B | C | 9.0 |
| Example 33* | (2) | (24) | C | B | B | C | 9.0 |
| Example 34 | (2) | (25) | C | C | B | C | 9.0 |
| Example 35 | (2) | (27) | C | C | B | C | 9.0 |
| Comparative Example 1 | (1) | (R-1) | D | D | B | D | 10.0 |
| Comparative Example 2 | (1) | (R-2) | C | C | C | D | 7.0 |
| Comparative Example 3 | (1) | (R-3) | C | C | C | D | 7.0 |
| Comparative Example 4 | (1) | (R-4) | D | D | C | D | 10.0 |
| Comparative Example 5 | (1) | (R-5) | A | D | D | A | 5.0 |
| Comparative Example 6 | (1) | (R-6) | D | D | C | D | 10.0 |
| Comparative Example 7 | (R-1) | (5) | A | B | A | A | 2.0 |
| Comparative Example 8 | (R-2) | (5) | A | B | A | A | 1.0 |
| Comparative Example 9 | (R-3) | (5) | B | B | A | B | 4.0 |

| | | | | | | | |
|---|---|---|---|---|---|---|---|
| *: Reference Examples | | | | | | | |

From the results shown in Table 2, it can be seen that the excellent developing property, printing image-forming property and printing durability and high processing property of developer are achieved by incorporating polyvinyl butyral into the image-recording layer, incorporating polyvinyl alcohol into the protective layer and using the developer containing the specific compound in the specific amount according to the invention.

It is also found that the developing property, printing image-forming property and printing durability are more improve by using the developer further containing a surfactant.

It is further found that the developing property is more improved while maintaining the excellent printing durability by using the developer further containing both a nonionic surfactant and an anionic surfactant.

It is moreover found that the stain in the non-image area can be decreased by using the developer further containing a water-soluble polymer compound.

It is furthermore found that the developing property is more improved by using polyvinyl butyral having an acid group.

## Claims

1. A method of preparing a lithographic printing plate, comprising:
exposing imagewise a lithographic printing plate precursor comprising a support, an image-recording layer containing a polymerization initiator, a polymerizable compound and polyvinyl butyral and a protective layer containing polyvinyl alcohol in this order to cure an exposed area of the image-recording layer,
removing an unexposed area of the image-recording layer and the protective layer using a development processing solution containing at least one compound selected from the group consisting of a phenol having from 6 to 10 carbon atoms and a compound represented by formula (1) shown below in an amount of 0.1 to 20% by weight thereby forming an image:
Xⁿ⁺(SCN⁻)ₙ Formula (1)
wherein Xⁿ⁺ represents a counter cation and n represents a valence of the counter cation X.

2. The method of preparing a lithographic printing plate as claimed in claim 1, wherein pH of the development processing solution is from 2.0 to 11.0.

3. The method of preparing a lithographic printing plate as claimed in claim 1 or 2, wherein pH of the development processing solution is from 5.0 to 10.7.

4. The method of preparing a lithographic printing plate as claimed in any one of claims 1 to 3, wherein the development processing solution further contains a surfactant.

5. The method of preparing a lithographic printing plate as claimed in claim 4, wherein the surfactant includes both a nonionic surfactant and an anionic surfactant.

6. The method of preparing a lithographic printing plate as claimed in any one of claims 1 to 5, wherein the development processing solution further contains a water-soluble polymer compound.

7. The method of preparing a lithographic printing plate as claimed in any one of claims 1 to 6, wherein the polyvinyl butyral contains an acid group.

## Patentansprüche

1. Verfahren zur Herstellung einer Lithografiedruckplatte, umfassend:
bildweises Belichten eines Lithografiedruckplattenvorläufers, der einen Träger, eine Bildaufzeichnungsschicht, die einen Polymerisationsinitiator, eine polymerisierbare Verbindung und Polyvinylbutyral enthält, und eine Schutzschicht, die Polyvinylalkohol enthält, in dieser Reihenfolge umfasst, um einen belichteten Bereich der Bildaufzeichnungsschicht zu härten;
Entfernen eines nicht-belichteten Bereichs der Bildaufzeichnungsschicht und der Schutzschicht unter Verwendung einer Entwicklungsverarbeitungslösung, die mindestens eine Verbindung, ausgewählt aus der Gruppe bestehend aus einem Phenol mit 6 bis 10 Kohlenstoffatomen und einer durch die nachstehende Formel (I) dargestellten Verbindung, in einer Menge von 0,1 bis 20 Gew.% enthält, wodurch ein Bild erzeugt wird:
Xⁿ⁺(SCN⁻)ₙ Formel (I)
worin Xⁿ⁺ ein Gegenkation darstellt und n die Wertigkeit des Gegenkations X darstellt.

2. Verfahren zur Herstellung einer Lithografiedruckplatte gemäß Anspruch 1, worin der pH-Wert der Entwicklungsverarbeitungslösung von 2,0 bis 11,0 beträgt.

3. Verfahren zur Herstellung einer Lithografiedruckplatte gemäß Anspruch 1 oder 2, worin der pH-Wert der Entwicklungsverarbeitungslösung von 5,0 bis 10,7 beträgt.

4. Verfahren zur Herstellung einer Lithografiedruckplatte gemäß irgendeinem der Ansprüche 1 bis 3, worin die Entwicklungsverarbeitungslösung ferner ein Tensid enthält.

5. Verfahren zur Herstellung einer Lithografiedruckplatte gemäß Anspruch 4, worin das Tensid sowohl ein nichtionisches als auch ein anionisches Tensid umfasst.

6. Verfahren zur Herstellung einer Lithografiedruckplatte gemäß irgendeinem der Ansprüche 1 bis 5, worin die Entwicklungsverarbeitungslösung ferner eine wasserlösliche Polymerverbindung enthält.

7. Verfahren zur Herstellung einer Lithografiedruckplatte gemäß irgendeinem der Ansprüche 1 bis 6, worin das Polyvinylbutyral eine Säuregruppe enthält.

## Revendications

1. Un procédé de préparation d'une plaque d'impression lithographique, comprenant:
l'exposition sous forme d'image d'un précurseur de plaque d'impression lithographique comprenant un support, une couche d'enregistrement d'image contenant un initiateur de polymérisation, un composé polymérisable et du butyral de polyvinyle et une couche de protection contenant de l'alcool polyvinylique dans cet ordre pour durcir une surface exposée de la couche d'enregistrement d'image,
l'élimination d'une surface non exposée de la couche d'enregistrement d'image et de la couche de protection en utilisant une solution de traitement de développement contenant au moins un composé choisi parmi le groupe constitué d'un phénol ayant de 6 à 10 atomes de carbone et d'un composé représenté par la formule (1) indiquée ci-dessous dans une quantité de 0,1 à 20% en poids formant ainsi une image:
Xⁿ⁺(SCN⁻)ₙ Formule (1)
dans laquelle Xⁿ⁺ représente un contre-cation et n représente une valence du contre-cation X.

2. Le procédé de préparation d'une plaque d'impression lithographique tel que revendiqué dans la revendication 1, dans lequel le pH de la solution de traitement de développement est de 2,0 à 11,0.

3. Le procédé de préparation d'une plaque d'impression lithographique tel que revendiqué dans la revendication 1 ou 2, dans lequel le pH de la solution de traitement de développement est de 5,0 à 10,7.

4. Le procédé de préparation d'une plaque d'impression lithographique tel que revendiqué dans l'une quelconque des revendications 1 à 3, dans lequel la solution de traitement de développement contient en outre un tensioactif.

5. Le procédé de préparation d'une plaque d'impression lithographique tel que revendiqué dans la revendication 4, dans lequel le tensioactif inclut à la fois un tensioactif non ionique et un tensioactif anionique.

6. Le procédé de préparation d'une plaque d'impression lithographique tel que revendiqué dans l'une quelconque des revendications 1 à 5, dans lequel la solution de traitement de développement contient en outre un composé polymère soluble dans l'eau.

7. Le procédé de préparation d'une plaque d'impression lithographique tel que revendiqué dans l'une quelconque des revendications 1 à 6, dans lequel le butyral de polyvinyle contient un groupe acide.
